# EUROPÄISCHE PATENTSCHRIFT

(11) **EP 2 456 071 B1**
(45) Veröffentlichungstag und Bekanntmachung des Hinweises auf die Patenterteilung: **27.09.2017**
(21) Anmeldenummer: 11009057.8
(22) Anmeldetag: 15.11.2011
(51) Int. Cl.: H03K 17/56, H03K 17/72

(54) **Schalter für durch eine Last fließenden Wechselstrom**
Switch for alternating current flowing through a load
Commutateur pour un courant alternatif passant à travers une charge

(30) Priorität: 17.11.2010 DE 102010051423
(43) Veröffentlichungstag der Anmeldung: 23.05.2012
(73) Patentinhaber: MS-Technik Mess- und Regelungstechnik GmbH & Co. KG, 24232 Schönkirchen (DE)
(72) Erfinder: Schacht, Sebastian, 24105 Kiel (DE)
(74) Vertreter: Hausfeld, Norbert

(56) Entgegenhaltungen:
- DD-A1- 222 458
- DE-A1- 2 443 930
- DE-A1- 2 624 044
- DE-C1- 3 123 907
- US-A- 4 302 687

## Beschreibung

Die Erfindung betrifft einen Schalter für durch eine Last fliessenden Wechselstrom höherer Leistung, mit zwei antiparallel verbundenen Thyristoren.

Schalter für Wechselströme höherer Leistungen werden insbesondere im Niederspannungs-Hochleistungs-Bereich, also z. B. zum Schalten ganzer Versorgungsnetze wie z. B. Netze zur Stromversorgung von Häusern und Wohnungen in Straßenzügen, zum Schalten von Fabrikationsbetrieben, Maschinen und dergleichen verwendet. Normalerweise verwendet man dazu mechanische Schalter, die kostengünstig und sehr verlustarm sind. Als Sicherungen werden aus denselben Gründen Schmelzsicherungen verwendet.

In Sonderfällen werden für diese Zwecke aber auch Schalter mit zwei antiparallel verbundenen Thyristoren verwendet. Sie haben den Vorteil, direkt elektronisch ansteuerbar zu sein. Sie sind sehr schnell. Ferner erlauben sie ein sehr präzises Schalten des Stromes, z.B. immer genau im Nulldurchgang, was grosse Vorteile hat. Nachteilig sind die hohen Kosten und die hohe Verlustleistung in den Thyristoren, die eine Kühlung erfordert und zu grossen Geräteabmessungen führt.

Erhebliche Probleme bestehen beim Haltestrom. Das ist der Strom, der beim Zünden eines Thyristors fließen muss, damit dieser leitfähig wird. Weitgehend derselbe Strom ist der, der mindestens fließen muss, bevor der Thyristor erlischt. Bei Hochleistungsthyristoren der hier fraglichen Art sind auch die dem jeweiligen Datenblatt entnehmbaren Halteströme entsprechend hoch und können in der Größenordnung 1 Ampere betragen.

Zwei wesentliche Probleme im Zusammenhang mit dem Haltestrom sind besonders störend.

Zunächst besteht das Problem, dass bei sehr hoher Lastimpedanz der bei der vorgegebenen Netzspannung fließende Strom sehr niedrig ist. Er kann bei sehr hoher Impedanz den notwendigen Haltestrom unterschreiten, so dass der Thyristor erlischt, bzw. gar nicht erst zünden kann.

Das ist z. B. der Fall, wenn überhaupt keine Last vorhanden ist, weil z. B. alle vorhandenen Verbraucher zur Nachtzeit abgeschaltet haben. Dann ist die Lastimpedanz unendlich und es kann kein Strom und eben auch kein Haltestrom fließen. Der Thyristor kann nicht zünden. Dasselbe gilt, wenn nur Verbraucher sehr geringer Leistung und damit hoher Impedanz angeschlossen sind.

Dieses Problem verdeutlicht sich am Beispiel eines Schalters, der ein sehr großes Haus mit hunderten von Wohnungen schalten soll. Betrachtet man dabei das Verhalten mitten in der Nacht, wenn im ganzen Haus nur ein einziger Kleinverbraucher im Standby-Betrieb angeschlossen ist, dann sieht man, dass der Thyristor seinen Haltestrom nicht erreichen kann und folglich nicht zünden kann. Der im Standby-Betrieb angeschlossene Kleinverbraucher bekommt folglich keine Spannung mehr.

Ein weiteres Problem ergibt sich bei plötzlich auftretenden Kurzschlüssen. Treten diese im Voll- oder Teillastbereich auf, so ist der plötzliche Stromanstieg durch den Kurzschluss nicht besonders gefährlich. Das ändert sich aber, wenn ein Kurzschluss dann auftritt, wenn wie im vorerwähnten Fall die vorhandene Last so klein ist, dass der Thyristor nicht zünden kann.

Bei aufgetretenem Kurzschluss können sehr hohe Ströme fließen. Der Thyristor, der bisher wegen der zu hochohmigen Last nicht zünden konnte, kann dies nun sofort. Das ist ungefährlich, wenn es unmittelbar nach dem Nulldurchgang, also bei niedriger Spannung und somit niedrigen Strömen geschieht. Passiert das aber zu einem späteren Phasenwinkel, also bei höherer Spannung, so ergeben sich angesichts des Kurzschlusses extrem hohe Ströme und zwar zu einem sehr ungünstigen Zeitpunkt, wenn nämlich der Thyristor am Beginn des Zündvorganges ist und nicht vollständig durchgeschaltet hat. Das ist für den Thyristor sehr gefährlich und kann letztlich zu seiner Zerstörung führen.

Zur Vermeidung der beiden diskutierten Probleme mit dem Haltestrom ist es wünschenswert, dass die beiden Thyristoren des Schalters grundsätzlich bei jeder Halbwelle zünden können und zwar unabhängig von der Impedanz der Last.

Zu diesem Zweck ist es im Stand der Technik bekannt, parallel zur zu versorgenden Last eine Hilfslast anzuordnen, die unabhängig von der Impedanz der Last einen Strom in Höhe des Haltestromes zieht. Damit wird gewährleistet, dass unter allen Umständen die Thyristoren in jeder Halbwelle zünden können. Die beiden genannten Probleme werden gelöst. Auch Kleinstverbraucher bleiben ständig mit Spannung versorgt. Bei schwacher Belastung plötzlich auftretende Kurzschlüsse führen nicht zur Zerstörung der Thyristoren.

Diese bekannte Lösung hat jedoch einen erheblichen Nachteil. Die Hilfslast erfordert einen Widerstand, der bei der angelegten Spannung mindestens den Haltestrom des Thyristors zieht, damit der Thyristor zünden kann. Der Thyristor sollte aber vorteilhaft schon sehr früh bei jeder Halbwelle zünden, also bei noch sehr niedriger Spannung. Fordert man eine Zündung schon bei einer Spannung von z.B. 40 Volt, so ergibt sich bei der vollen Spannung von z.B. 400 Volt die zehnfache Spannung und somit die hundertfache Verlustleistung an dem Hilfswiderstand. Die an dem Widerstand entstehenden Verlustleistungen können mehrere Kilowatt betragen. Diese wegen der somit erforderlichen Kühleinrichtungen sehr grossen Widerstände werden daher entfernt vom Schalter angeordnet, damit der Platzaufwand und die Verlustwärme nicht stört, wobei man bedenken muss, dass die Thyristoren selbst schon mehrere hundert Watt Verlustleistung produzieren.

Eine solche vom Schalter getrennte Anordnung der mit dem Widerstand gebildeten Hilfseinrichtung ist jedoch bei vielen Anwendungsfällen nicht möglich oder zumindest äußerst unpraktisch.

Eine Lösung der Haltestromprobleme ergibt sich aus der DE 26 24 044 A1. Dort ist ein Nebenschlussglied vorgesehen, das zwischen Katode und Gate des Thyristors geschaltet ist und für ausreichenden Haltestrom sorgt.

Die DD 222 458 A1 zeigt eine Schaltung bei der eine Hilfsstromquelle mit Pluspol an die Anode und mit Minuspol an die Katode des ihr zugehörigen Thyristors angeschlossen ist und für ausreichenden Haltestrom sorgt. Diese Hilfsstromquelle verfügt über eine eigene Gleichspannungsquelle die in keinem Zusammenhang mit der zugehörigen Zündeinrichtung steht.

Die letztgenannte Konstruktion hat jedoch den Nachteil, dass für die Hilfseinrichtung zur Sicherung des Haltestromes und für die Zündeinrichtung je eine Spannungsquelle zur Versorgung erforderlich sind.

Aus DE 31 23 907 C1 ist eine Schaltungsanordnung bekannt, bei der Thyristoren in antiparalleler Anordnung verwendet werden, um einen Betrieb der Schaltung in beliebiger Stromrichtung zu ermöglichen. Zur Unterbrechung des Stromkreises durch einen Thyristor bei Lastströmen oberhalb des Haltestroms wird vorgeschlagen, eine Löscheinrichtung parallel zum Thyristor anzuordnen, die bei Bedarf einen Löschstrom entgegen der Laststromrichtung erzeugt.

Die Aufgabe der vorliegenden Erfindung besteht darin, bei einem Schalter für durch eine Last fliessenden Wechselstrom höherer Leistung, mit zwei antiparallel verbundenen Thyristoren, die oben diskutierten Probleme im Zusammenhang mit dem Haltestrom auf vorteilhafte Weise zu lösen.

Diese Aufgabe wird mit den Merkmalen des Anspruches 1 gelöst.

Erfindungsgemäß sind an den Thyristoren Hilfsstromquellen vorgesehen, die unmittelbar am Thyristor den Haltestrom erzeugen. Die Hilfsstromquelle ist so angeschlossen, dass der von ihr erzeugte Strom nur durch die Hilfsstromquelle und durch den zugehörigen Thyristor fließt. Bei der Hilfsstromquelle reichen daher sehr geringe Spannungen zur Erzeugung des Haltestromes. Die entsprechenden Leistungen sind äußerst gering und können im Bereich weniger Watt liegen. Die Hilfseinrichtung kann daher ohne zusätzliche Wärmebelastung unmittelbar am Schalter angeordnet sein. Dabei sind die Zündeinrichtung und die Hilfsstromquelle von der selben Gleichspannungsquelle versorgt, was den Aufbau wesentlich vereinfacht und verbilligt.

Der Schalter lässt sich also sehr klein in weitgehend beliebigen Bauformen ausbilden und kann insbesondere vorteilhaft gemäß Anspruch 2 in der Bauform einer NH-Sicherung mit Kontaktmessern ausgebildet sein. Der Schalter kann also in einem Schaltschrank anstelle einer Sicherung eingesetzt werden und kann z. B. als elektronische Sicherung ausgebildet sein.

Vorteilhaft gemäß Anspruch 3 ist die Hilfsstromquelle dazu ausgebildet, den Stromregler nur dann zu öffnen, wenn an ihm die korrekte Polarität anliegt. Dadurch wird die Hilfsstromquelle vor Zerstörung durch Anlegen falscher Polarität geschützt. Das geschieht selbsttätig, also ohne die Hilfe äusserer Steuerungen, wodurch sich ein unter allen Umständen sehr sicherer Schutz ergibt.

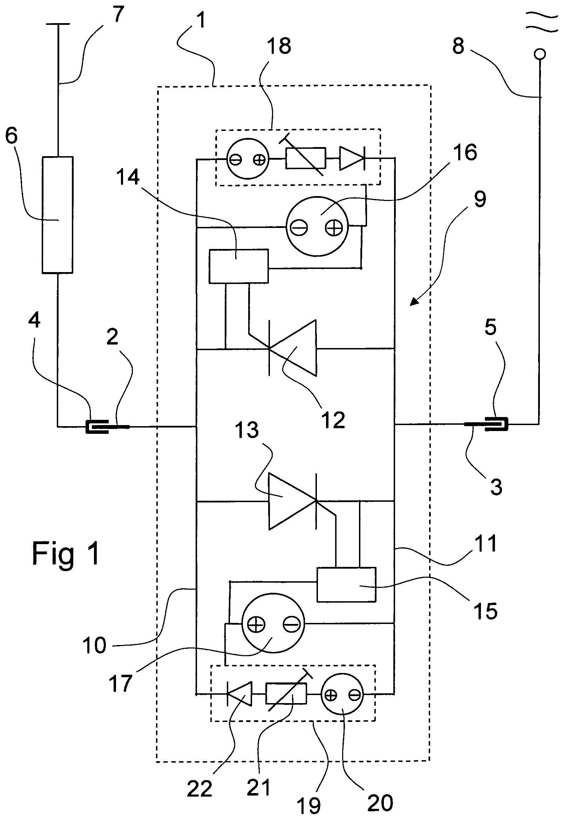

In der Zeichnung ist die Erfindung beispielsweise und schematisch in einer einzigen Fig. 1 dargestellt, die das elektrische Schaltbild eines erfindungsgemäßen Schalters zeigt.

Fig. 1 zeigt in einem stark schematisierten Schaltbild einen erfindungsgemäßen Schalter 9, der in einem gestrichelt dargestellten Gehäuse 1 untergebracht ist. Aus dem Gehäuse ragen zwei Messer 2, 3 heraus, die zur Kontaktierung in Messeraufnahmen 4, 5 gesteckt sind, welche einerseits an eine Last 6 eines angeschlossenen, zu versorgenden Netzes und über diese an einem Nullleiter 7 angeschlossen sind und andererseits an eine Phase 8 des Netzes.

Die Messeraufnahmen 4, 5 sitzen beispielsweise in einem Anschlussschrank des die Last 6 verwendenden Verbrauchers. Die Messeraufnahmen 4, 5 sind ausgebildet zur Aufnahme handelsüblicher Messersicherungen. Mehrere Paare von Messeraufnahmen können beispielsweise für drei Sicherungen eines Drehstromnetzes vorgesehen sein.

Der in dem Gehäuse 1 vorgesehene Schalter 9 ist mit seinem elektrischen Schaltbild dargestellt. Hauptleiter 10 und 11 sind an die Messer 2 bzw. 3 angeschlossen. Zwischen den Hauptleitern 10 und 11 sind alle Bauelemente des Schalters 9 angeschlossen.

Zwischen den Hauptleitern 10 und 11 sind zwei Thyristoren 12 und 13 in antiparalleler Anordnung angeschlossen und sitzen im Stromweg zwischen der Netzphase 8 und dem Nullleiter 7 mit einer maximalen Spannungsdifferenz von z. B. 400 Volt. Es liegt eine Wechselspannung alternierender Polarität an, wobei Halbwellen abwechselnd durch den Thyristor 12 und den Thyristor 13 fließen können.

Dazu müssen die Thyristoren allerdings gezündet werden. Dies geschieht durch anlegen eines Impulses mit positive Spannung gegenüber der Kathode, am Gate.

Im dargestellten Ausführungsbeispiel sind dazu Zündeinrichtungen vorgesehen, die nur schematisch jeweils mit einem Kasten angedeutet sind, und zwar eine Zündeinrichtung 14 am Thyristor 12 und eine Zündeinrichtung 15 am Thyristor 13. Wie dem Schaltbild entnehmbar, sind die Zündeinrichtung 14, 15, jeweils mit einer Leitung an das Gate des zugehörigen Thyristors 12, 13, angeschlossen, mit einer anderen Leitung an dessen Kathodenleitung und mit einer dritten Leitung an den Pluspol einer Gleichspannungsquelle 16, 17, die für jeden Transistor vorgesehen ist und die jeweils mit ihrem Minuspol an die Kathode des zugehörigen Thyristors 12 bzw. 13 angeschlossen ist.

Äußere Zuleitungen, die wiederum die Gleichspannungsquellen 16, 17, versorgen oder steuern, sind zur Vereinfachung der Darstellung weggelassen. Ebenso sind Zuführungen zu den Zündeinrichtungen 14, 15, weggelassen, die diese mit Steuersignalen und dergleichen versorgen, z.B. um zu Beginn jeder Halbwelle den entsprechenden Thyristor zu zünden.

Soweit wie bislang der Schalter 9 beschrieben ist, ist er geeignet, bei entsprechender Ansteuerung der Zündeinrichtungen 14, 15, die Thyristoren 12 und 13 abwechselnd zu zünden, so dass diese jeweils eine Halbwelle des Wechselstroms durchlassen.

Ein Thyristor kann Strom leiten wenn er mit einer Spannung mit Plus an der Anode beaufschlagt ist. Wenn also die Spannung am Messer 3 höher liegt als am Messer 2, kann der Thyristor 12 leiten. Bei umgekehrter Polarität, also bei der nächsten Halbwelle, kann der Thyristor 13 leiten. Am Ende einer jeden Halbwelle erlischt der zuvor leitende Thyristor, wenn die Spannung so klein wird, dass der Haltestrom unterschritten wird.

Zu Beginn einer jeden Halbwelle muss also stets der entsprechende Thyristor gezündet werden. Das setzt allerdings voraus, dass ein Strom durch die Last 6 fließen kann, der mindestens dem Haltestrom des Thyristors entspricht. Wenn die Last zu hochohmig ist, kann normalerweise nicht gezündet werden.

Die Erfindung sieht daher für jeden Thyristor eine Hilfsstromquelle 18, 19, vor. Die Hilfsstromquellen sind in der Schaltung gestrichelt dargestellt. Ihre wesentlichen Komponenten sind stark schematisiert dargestellt.

Die Hilfsstromquellen 18, 19 sitzen jeweils zwischen den Hauptleitern 10 und 11, und zwar antiparallel. Sie enthalten jeweils in Reihe eine Gleichspannungsquelle 20, einen Stromregler 21 sowie eine Diode 22. Diese drei Komponenten sind bei der Hilfsstromquelle 19 mit Bezugszeichen versehen, die sinngemäß auch für die Hilfsstromquelle 18 gelten.

Mit einer Gleichspannungsquelle 20 und einem Stromregler 21 ist die Grundschaltung einer Stromquelle mit geregeltem Ausgangsstrom dargestellt. Die Gleichspannungsquelle 20 und der Stromregler 21 sind derart dimensioniert und ausgebildet, dass sie im Stromkreis durch die Hilfsstromquelle und den zugehörigen Thyristor den erforderlichen Haltestrom erzeugen, und zwar mindestens in Höhe des erforderlichen Mindestwertes, oder auch einen höheren Strom, jedoch nach Möglichkeit nicht zu hoch, um nicht unnötige Verlustleistung zu produzieren.

Die Diode 22 ist erforderlich zum Schutz der Hilfsstromquelle 18, 19, wenn die zwischen den Messern 2, 3, anliegende Netzspannung höhere Werte in Öffnungsrichtung des zugehörigen Transistors annimmt. Dann könnte ein Rückwärtsstrom durch die Hilfsstromquelle diese zerstören.

Eine weitere nicht dargestellte Schutzeinrichtung sorgt dafür, dass z. B. die Hilfsstromquelle 19 nur dann betrieben wird, wenn ihr zugehöriger Thyristor 13 in Durchlassrichtung arbeitet, nicht aber, wenn der andere Thyristor 12 in seiner Durchlassrichtung arbeiten kann, aber sperrt.

Weitere nicht dargestellte Einrichtungen, z.B. in Form von Dioden, Schaltern, Steuerungen und dergleichen, liefern z.B. Synchronisationssignale und sorgen dafür, dass die Hilfsstromquelle zusammen mit der Zündeinrichtung aktiv und inaktiv geschaltet wird.

Die Versorgungsspannung für die Hilfsstromquelle 18, 19, kommt jeweils aus der Gleichstromquelle 16, 17, die nicht nur die jeweilige Zündeinrichtung, sondern auch die jeweilige Hilfsstromquelle versorgt.

Ein typischer Anwendungsfall für den dargestellten Schalter 9 ist ein unklarer Störungsfall in einem Netz mit z. B. bisweilen auftretenden Kurzschlüssen. Immer wieder müssen Sicherungen ersetzt werden und die Fehlersuche ist aufwändig.

Dann wird die vom Kurzschluss betroffene Sicherung durch den Schalter 9 ersetzt und dieser wird als Sicherung betrieben. Es wird also zusätzlich eine nicht dargestellte Strommesseinrichtung vorgesehen, die die Zündeinrichtungen 14, 15, derart ansteuert, dass bei Überschreiten des eingestellten Abschaltstromes die Zündeinrichtungen gesperrt werden, so dass sie nicht mehr zünden und somit die Thyristoren 12, 13, stromlos bleiben. Nach Beseitigung des Kurzschlusses kann die Sicherung auf Knopfdruck oder automatisch wieder eingeschaltet werden.

Der dargestellte Schalter kann auch z. B. bei der Fehlersuche eingesetzt werden. Dazu können die Zündeinrichtungen 14, 15, derart betrieben werden, dass die Thyristoren 12, 13 dauernd ausgeschaltet sind und nur einmalig auf Befehl einen Stromimpuls auf die Last 6 geben, um daran Messungen vorzunehmen.

Erst die erfindungsgemässe Ausbildung des Schalters 9 ermöglicht diese Betriebsweise, da sie unter allen Umständen den vorschriftsmässigen Haltestrom und damit den Schaltbetrieb ermöglicht, also insbesondere auch dann, wenn, wie man dies normalerweise aus Vorsichtsgründen tut, bei dem Test die empfindlichen Verbraucher ausgeschaltet, die Last also extrem hochohmig ist.

Die im Schalter 9 anfallenden Verlustleistungen sind ersichtlich sehr gering. Die Zündeinrichtungen 14 und 15 sowie die Hilfsstromquellen 18 und 19 verbrauchen wenige Watt. Die Hauptleistung fällt in den Thyristoren 12, 13 an und kann wenige einhundert Watt betragen.

Solche Leistungen lassen sich auf relativ kleinem Raum beseitigen, z. B. mit Hilfe von Kühlblechen und Ventilatoren. Das Gehäuse 1 kann daher im Wesentlichen die Abmessungen einer Niederspannungs-Hochleistungs-Sicherung vom Messertyp aufweisen, also im Volumenbereich bis etwa ein Liter. Dadurch wird der beschriebene Einsatz als elektronischer Ersatz einer Schmelzsicherung erst möglich.

## Patentansprüche

1. Schalter (9) für durch eine Last (6) fliessenden Wechselstrom höherer Leistung, mit zwei antiparallel verbundenen Thyristoren (12, 13) mit jeweils zugehöriger Zündeinrichtung (14, 15), sowie mit einer Hilfseinrichtung zur Sicherung des Haltestromes bei zu hochohmiger Last, die für jeden Thyristor (12, 13) eine Hilfsstromquelle (18, 19) aufweist, die mit ihrem Pluspol an die Anode und mit ihrem Minuspol an die Kathode ihres zugehörigen Thyristors (12, 13) angeschlossen ist und die derart gesteuert ist, dass sie während der Zeiten, in denen der Thyristor (12, 13) leitend sein soll, einen Strom erzeugt, der gleich oder grösser als der Haltestrom des Thyristors (12, 13) ist, wobei bei jedem Thyristor (12, 13) des Schalters (9) die Zündeinrichtung (14, 15) und die Hilfsstromquelle (18, 19) von einer Gleichspannungsquelle (16, 17) versorgt sind, deren Minuspol mit der Kathode des Thyristors (12, 13) verbunden ist.

2. Schalter nach Anspruch 1, **dadurch gekennzeichnet, dass** der Schalter (9) in der Bauform einer NH-Sicherung mit Kontaktmessern (2, 3) ausgebildet ist.

3. Schalter nach einem der vorhergehenden Ansprüche, **dadurch gekennzeichnet, dass** die Hilfsstromquelle (18, 19) derart ausgebildet ist, dass sie den Stromregler (21) nur öffnet, wenn die Polarität der anliegenden Spannung so ist, dass ihr zugehöriger Thyristor (12, 13) in Durchlassrichtung arbeiten kann.

## Claims

1. A switch (9) for alternating current flowing through a load (6), said current having an increased power, wherein said switch (9) has two thyristors (12, 13) that are connected in an antiparallel manner and each have an associated ignition device (14, 15), and wherein said switch (9) has an auxiliary device for securing the holding current if the load has an excessively high resistance, said auxiliary device having an auxiliary source (18, 19) for each thyristor (12, 13), said auxiliary source (18, 19) being connected to the anode of its associated thyristor (12, 13) with its positive pole and to the cathode with its negative pole and being controlled such that, in times where the thyristor (12, 13) is intended to be conductive, it generates a current that is equal to or greater than the holding current of the thyristor (12, 13), wherein in each thyristor (12, 13) of the switch (9) the ignition device (14, 15) and the auxiliary source (18, 19) are supplied from a direct current voltage source (16, 17) the negative pole of which is connected to the cathode of the thyristor (12, 13).

2. The switch in accordance with Claim 1, **characterised in that** the switch (9) has the structural form of an NH fuse with contact blades (2, 3).

3. The switch in accordance with any one of the preceding claims, **characterised in that** the auxiliary source (18, 19) is formed in such a way that it opens the current regulator (21) only if the polarity of the applied voltage is such that its associated thyristor (12, 13) can work in conducting direction.

## Revendications

1. Commutateur (9) pour un courant alternatif de puissance traversant une charge (6), avec deux thyristors en connexion antiparallèle (12, 13) respectivement dotés d'un dispositif d'amorçage correspondant (14, 15), et avec un dispositif auxiliaire assurant le courant de maintien en cas de charge de valeur ohmique trop élevée et présentant pour chaque thyristor (12, 13) une source de courant auxiliaire (18, 19) dont le pôle plus est branché sur l'anode et le pôle moins sur la cathode du thyristor correspondant (12, 13), ce dispositif étant commandé de façon à produire pendant les phases conductrices du thyristor (12, 13) un courant égal ou supérieur au courant de maintien du thyristor (12, 13), le dispositif d'amorçage (14, 15) et la source de courant auxiliaire (18, 19) de chaque thyristor (12, 13) du commutateur (9) étant alimenté par une source de tension continue (16, 17) dont le pôle moins est relié à la cathode du thyristor (12, 13).

2. Commutateur selon la revendication 1, **caractérisé en ce que** le commutateur (9) est réalisé sous forme de coupe-circuit B.T. à haut pouvoir de coupure pourvu de lames de contact.

3. Commutateur selon l'une des revendications précédentes, **caractérisé en ce que** la source de courant auxiliaire (18, 19) est conçue de façon à n'ouvrir le régulateur de courant (21) que si la polarité de la tension appliquée est telle que le thyristor (12, 13) correspondant puisse fonctionner en sens passant.
